# EUROPEAN PATENT APPLICATION

(11) **EP 0 542 481 A2**
(43) Date of publication of application: **19.05.1993**
(21) Application number: 92310152.1
(22) Date of filing: 05.11.1992
(51) Int. Cl.: H01L 21/311, H01L 21/3105

(54) **Method for reducing dielectric contamination in integrated circuits**

(30) Priority: 12.11.1991 US 792129
(71) Applicant: AT&T Corp., New York, NY 10013-2412 (US)
(72) Inventor: Herring, Felicia Garrett, Bethlehem, Pennsylvania 18017 (US); Twiford, Michael Scott, Bath, Pennsylvania 18014 (US); Vitkavage, Daniel Joseph, Zionsville, Pennsylvania 18092 (US)
(74) Representative: Johnston, Kenneth Graham

(57) **Abstract**

Contamination of dielectric layers(e.g. 5) is reduced by removing a surface layer of the dielectric material(e.g. 5) by a chemical reaction with neutral species. The process proceeds at low temperature, and low energy and does not substantially attack any material underneath a patterned dielectric(e.g. 5).

## Description

### Technical Field

This invention relates to a method for reducing contamination of dielectric layers in integrated circuits by impurities such as sodium or heavy metal ions or atoms.

### Background of the Invention

Contamination is a pervasive problem in semiconductor integrated circuit manufacture. The contamination may take many forms including unwanted impurities in the channel of a field effect transistor or unwanted particles in critical device regions. Contamination may also be in the form of mobile ions, such as sodium ions, present in dielectric layers. Mobile ions are undesirable because they may create undesirable effects, such as shifts in the threshold voltage. Of course, the dielectric layer may have other contaminants as well.

Dielectric contamination may occur in several ways. For example, an oxide may be deposited and patterned. Contaminants in the dielectric may come from the resist used in the patterning process or from the etching machine used to transfer the pattern into the dielectric. Although the contaminants may be primarily on the surface initially, an etching process at elevated temperatures is likely to drive the contaminants into the dielectric through diffusion mechanisms. The contaminants may be driven further into the dielectric if charged particles are used during the etching process.

Accordingly, methods have been developed which reduce or eliminate dielectric contamination. See, for example, *United States Patent 4,980,301* issued on December 25, 1990 to Harrus et al. for description of an exemplary technique for reducing contamination of a dielectric top layer. The technique removes the topmost portion of a dielectric layer which has been exposed to a source of contamination.

Techniques which remove portions of the dielectric layer may be difficult to apply in some circumstances. For example, the dielectric may have been patterned to expose selected portions of the underlying material, such as a metal. A common technique uses buffered HF with ethylene glycol to remove a surface layer from the dielectric. However, the buffered HF may attack exposed portions of the material. The technique used to remove portions of the contaminated dielectric should not remove or attack significant portions of the exposed underlying material.

### Summary of the Invention

Dielectric contamination is reduced in integrated circuit manufacture by forming patterns on a substrate; depositing a dielectric on said patterns; processing the dielectric and thereby exposing the dielectric to a source of contamination; and removing a surface layer of the dielectric by chemical reaction with a vapor phase neutral atomic species. In one preferred embodiment, the processing comprises patterning the dielectric to expose portions of the underlying material. In a further preferred embodiment, the material comprises a metal, such as aluminum.

In another aspect of the invention, the dielectric surface in washed in a solvent, such as water or isopropyl alcohol, after the removing step has been completed. This step removes contaminants that are not in the surface layer but which are exposed after a surface layer has been removed.

### Brief Description of the Drawing

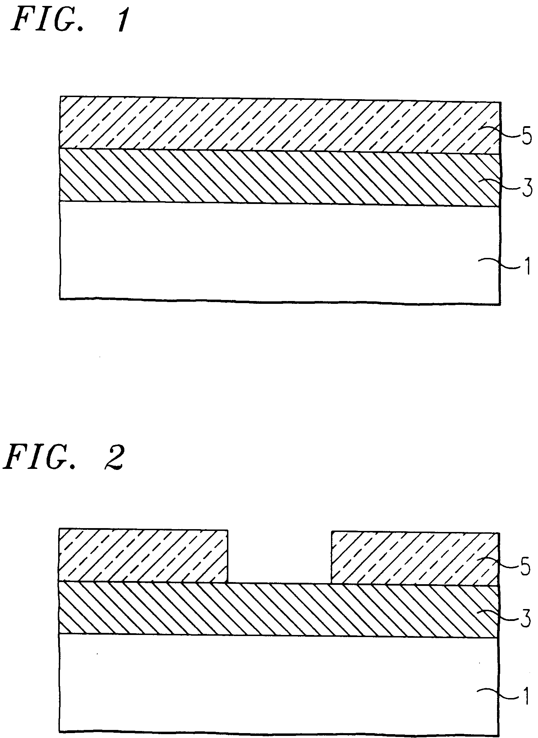

FIGs. 1 and 2 are sectional views useful in explaining the method of this Invention.

For reasons of clarity, the elements depicted are not drawn to scale. Identical numerals in different figures represent identical elements.

### Detailed Description

FIG. 1 is a sectional view of an integrated circuit at an intermediate stage of fabrication according to this invention. Depicted are substrate 1, material 3, and dielectric layer 5. The term *substrate* is used to mean material which is underneath and supports another material. The substrate may be a silicon wafer, a field oxide, etc. The silicon wafer may have a surface which has been modified by further processing, such as doping to form source/drain regions, etc. Material 3 may be a metal, such as aluminum, or another metal used in semiconductor manufacture. Material 3 will have been patterned. It will also be appreciated that a wafer with a modified surface will have patterns on the surface. Dielectric layer 5 is typically a deposited oxide. The structure depicted will be readily formed by those skilled in the art, and so further description of its fabrication are not required.

At the stage depicted, the structure has been subjected to a processing step which exposes the dielectric to a source of contaminants. Likely contaminants include mobile ions, such as sodium, or heavy metals.

A portion of the dielectric layer is now removed by chemical reaction with a vapor phase neutral atomic species. An exemplary apparatus is a downstream etcher. Such apparatus is now well known to those skilled in the art and need not be described in detail. Essentially, the apparatus has means for introducing the precursor etching gas into a plasma source, and means for holding the wafer with diffuser plates between the wafer and the source. Exemplary precursor gases include NF₃, CF₄, andSF₆. The atomic species is fluorine. The plasma cracks the precursor gases into components. The diffuser plates eliminate any direct path between the source and the wafer, unwanted (charged) species recombine on the diffuser plates and only the neutral atomic species pass through the plates. Those skilled in the art will readily select appropriate gases, considering the compositions of the layers. For example, for an oxide layer 5 over layer 3 of aluminum, NF₃ is an expedient choice. Other gases will be readily selected for this and other materials combinations given the realization that the species is neutral and reacts with the material of layer 5.

The method described is desirable because it proceeds at low temperature and low energies. There is therefore no ion bombardment of the surface. The low temperature and the lack of ion bombardment reduce the likelihood that the contaminants will be driven further into the dielectric. All contaminants may not be removed by the process just described but rather may be brought to the surface of the dielectric or uncovered. In such a case, the surface may be rinsed in a solvent, such as water or isopropyl alcohol, to remove the contaminants.

FIG. 2 is a sectional view at a later stage of manufacture than is depicted in FIG. 1. The dielectric 5 has been patterned to expose selected portions of the underlying material which is depicted as a metal, such as aluminum. The surface is now treated as was described with respect to FIG. 1. However, the neutral species do not significantly react with or attack the aluminum.

Variations of the embodiments described will be readily thought of by those skilled in the art. For example, layer 3 may be omitted.

## Claims

1. A method of semiconductor integrated circuit manufacture comprising the steps of:
forming patterns on a substrate(e.g. 1);
depositing a dielectric(e.g. 5) on said patterns;
processing said dielectric(e.g. 5), said processing exposing said dielectric(e.g. 5) to a source of contamination; and
removing a surface layer of said dielectric(e.g. 5) by chemical reaction with a vapor phase neutral atomic species.

2. A method as recited in claim 1 in which said processing comprises the step of patterning said dielectric(e.g. 5) to expose portions of the underlying material(e.g. 3).

3. A method as recited in claim 2 in which said underlying material(e.g. 3) comprises a metal.

4. A method as recited in claim 3 in which said metal comprises aluminum.

5. A method as recited in claim 1 in which said atomic species is fluorine.

6. A method as recited in claim 1 comprising the further step of washing said dielectric(e.g. 5) in a solvent after said removing.

7. A method as recited in claim 6 in which said solvent comprises at least one member selected from the group consisting of water and isopropyl alcohol.
